# EUROPEAN PATENT APPLICATION

(11) **EP 2 866 015 A1**
(43) Date of publication of application: **29.04.2015**
(21) Application number: 13807695.5
(22) Date of filing: 12.06.2013
(51) Int. Cl.: G01N 1/06, G01N 1/28

(54) **DROPLET CUTTING METHOD AND DROPLET CROSS-SECTION ANALYSIS METHOD**

(30) Priority: 21.06.2012 JP 2012139454
(71) Applicant: Nitto Denko Corporation, Ibaraki-shi, Osaka 567-8680 (JP)
(72) Inventor: MAENO, Youhei, Ibaraki-shi Osaka 567-8680 (JP)
(74) Representative: Müller-Boré & Partner Patentanwälte PartG mbB
(86) International application number: PCT/JP2013/066187
(87) International publication number: WO 2013/191049

(57) **Abstract**

Provided is a droplet cutting method capable of cutting a droplet easily to expose its cross-section. Also provided is a droplet cross-section analysis method, including analyzing a cross-section exposed through cutting by such cutting method. A droplet cutting method of the present invention is a method of cutting a droplet to expose a cross-section, the method including: placing a droplet on a surface of a carbon nanotube aggregate including a plurality of carbon nanotubes; cooling the droplet to a cooling temperature equal to or less than a temperature at which the droplet is solidified; and cutting the droplet. A droplet cross-section analysis method of the present invention includes analyzing a cross-section exposed through cutting by the droplet cutting method of the present invention.

## Description

### Technical Field

The present invention relates to a droplet cutting method. More particularly, the present invention relates to a droplet cutting method capable of cutting a droplet easily to expose its cross-section. The present invention also relates to a droplet cross-section analysis method, including analyzing a cross-section exposed through cutting by such cutting method.

### Background Art

In recent years, structure control at a nano-scale level has been demanded along with miniaturization of various products and materials. In this connection, structural analysis at a nano-scale level has been required.

Particularly recently, the structure control at a nano-scale level has often involved not only control of a surface structure but also control of an inner structure. In this connection, not only analysis of a surface structure but also analysis of an inner structure has been required for the structural analysis at a nano-scale level.

Analysis of an inner structure of a fine sample has been conducted by exposing a cross-section of the sample and observing the cross-section. As a method of exposing the cross-section of the fine sample, polishing processing has been adopted since a long time ago, but recently, focused ion beam (FIB) processing has been increasingly adopted as means for exposing the cross-section easily and accurately.

There has been proposed a method of analyzing an inner structure of a fine sample in three dimensions, involving utilizing FIB processing and combining the FIB processing and scanning electron microscope (SEM) analysis (see, for example, Patent Literature 1). In the method, structural analysis in three dimensions is conducted by performing the FIB processing and the SEM analysis intermittently and repeatedly, and sterically reconstructing obtained images.

In analysis of an inner structure at a nano-scale level, a target for the analysis has been hitherto limited to a solid component or a viscous liquid component, because it is required to expose a cross-section of the target with fixing its structure. For example, when a material containing as a main component a viscous liquid component such as a pressure-sensitive adhesive is subjected to FIB processing, the material is cooled to low temperature by using liquid nitrogen or the like in order to suppress a structural change due to evaporation under high vacuum or the like.

However, in the case of a liquid sample containing as a main component a low-viscosity liquid component, such as an emulsion, it is extremely difficult to expose a cross-section of such sample with fixing its structure by a conventional FIB processing method. Inparticular, upon exposure of a cross-section of such liquid sample, the structure needs to be fixed in a droplet state. However, FIB processing with sufficient fixation of a droplet has not been realized heretofore.

### Citation List

### Patent Literature

[PTL 1] JP 11-213935 A

### Summary of Invention

### Technical Problem

It is an object of the present invention to provide a droplet cutting method capable of cutting a droplet easily to expose its cross-section. It is another object of the present invention to provide a droplet cross-section analysis method, including analyzing a cross-section exposed through cutting by such cutting method.

### Solution to Problem

A droplet cutting method of the present invention is a method of cutting a droplet to expose a cross-section, the method including: placing a droplet on a surface of a carbon nanotube aggregate including a plurality of carbon nanotubes; cooling the droplet to a cooling temperature equal to or less than a temperature at which the droplet is solidified; and cutting the droplet.

In a preferred embodiment, the droplet has a contact angle of 110 degrees or more with respect to the surface.

In a preferred embodiment, the cutting is performed by focused ion beam processing.

In a preferred embodiment, the cooling temperature is -100°C or less.

In a preferred embodiment, the carbon nanotubes each have a plurality of walls, a distribution width of a wall number distribution of the carbon nanotubes is 10 walls or more, and a relative frequency of a mode of the wall number distribution is 25% or less.

In a preferred embodiment, the carbon nanotubes each have a plurality of walls, a mode of a wall number distribution of the carbon nanotubes is present at 10 or less walls in number, and a relative frequency of the mode is 30% or more.

A droplet cross-section analysis method of the present invention includes analyzing a cross-section exposed through cutting by the droplet cutting method of the present invention.

### Advantageous Effects of Invention

According to one embodiment of the present invention, the droplet cutting method capable of cutting a droplet easily to expose its cross-section can be provided. According to another embodiment of the present invention, the droplet cross-section analysis method, including analyzing a cross-section exposed through cutting by such cutting method can be provided.

### Brief Description of Drawings

FIG. 1 is a schematic sectional view of an example of a carbon nanotube aggregate to be used in a preferred embodiment of the present invention.
FIG. 2 is a schematic sectional view of an apparatus for producing the carbon nanotube aggregate.
FIG. 3 is a photographic view provided by a scanning electron microscope (SEM) showing a state in which a droplet is placed on the surface of a carbon nanotube aggregate in Example 1, the photographic view being taken from above the surface.
FIG. 4 is a photographic view provided by a scanning electron microscope (SEM) showing a state of a cross-section exposed through cutting by focused ion beam (FIB) processing in Example 1.

### Description of Embodiments

### «Droplet cutting method»

A droplet cutting method of the present invention is a method of cutting a droplet to expose its cross-section, the method including: placing a droplet on the surface of a carbon nanotube aggregate including a plurality of carbon nanotubes; cooling the droplet to a cooling temperature equal to or less than a temperature at which the droplet is solidified; and cutting the droplet.

As the droplet to be cut, any appropriate droplet may be adopted as long as the droplet is solidified by cooling. The term "solidified" as used herein means a state in which a structure is fixed in a state of being placed on the surface of a carbon nanotube aggregate to be used in the droplet cutting method of the present invention. Although examples of such droplet include a water droplet, an emulsion droplet, a droplet of any other single-component liquid, and a droplet of any other multi-component liquid, any appropriate droplet other than those droplets may be adopted as long as the droplet is solidified by cooling. In addition, the droplet to be cut may be a high-viscosity droplet or a low-viscosity droplet.

As the size of the droplet to be cut, any appropriate size may be adopted. One main object of the droplet cutting method of the present invention is to analyze the structure of a fine sample, in particular. Therefore, the size of the droplet to be cut is preferably from 0.01 µm to 10,000 µm, more preferably from 0.05 µm to 5,000 µm, still more preferably from 0.1 µm to 1,000 µm, particularly preferably from 0.5 µm to 500 µm, most preferably from 1 µm to 100 µm, in terms of the particle diameter (maximum particle diameter in the case of a shape other than a true spherical shape) of the droplet.

As a method of placing the droplet on the surface of a carbon nanotube aggregate, any appropriate method may be adopted as long as the method enables secure formation of the droplet on the surface of the carbon nanotube aggregate. It should be noted that the droplet may be placed on any surface of the carbon nanotube aggregate, but is preferably placed on a surface that is formed from one longitudinal end of the carbon nanotube aggregate from the viewpoint of exhibiting effects of the present invention more effectively.

As a method of cooling the droplet, any appropriate method may be adopted as long as the droplet is solidified by cooling. Examples of such cooling method include rapid freezing using liquid nitrogen and rapid freezing using a cryostream.

As a cooling temperature of the droplet, any appropriate cooling temperature may be adopted depending on the kind of the droplet as long as the cooling temperature is equal to or less than a temperature at which the droplet is solidified. The cooling temperature is preferably -100°C or less, more preferably -120°C or less, still more preferably -150°C or less from the viewpoint of performing cutting easily and accurately.

As a method of cutting the droplet, any appropriate method may be adopted as long as the method enables accurate exposure of a cross-section. One main object of the droplet cutting method of the present invention is to analyze the structure of a fine sample, in particular. Therefore, a preferred example of the cutting method is focused ion beam (FIB) processing. As the conditions for focused ion beam (FIB) processing, any appropriate conditions may be adopted depending on the kind, size, and the like of the droplet to be cut. The cutting may be performed only on the droplet to be cut, or on at least a part of a carbon nanotube aggregate on which the droplet is placed, together with the droplet to be cut.

In the droplet cutting method of the present invention, a droplet is placed on the surface of a specific carbon nanotube aggregate, and thereby, the placed droplet can maintain its state of having a good spherical shape by virtue of an excellent lotus effect (super water repellent effect) of the carbon nanotube aggregate. As an indicator showing the state of having a good spherical shape, there is given a contact angle of the droplet with respect to the surface of the carbon nanotube aggregate. In the present invention, the contact angle is preferably 110 degrees or more, more preferably 115 degrees or more, still more preferably 120 degrees or more, particularly preferably 125 degrees or more, most preferably 130 degrees or more.

In the droplet cutting method of the present invention, a droplet is placed on the surface of a specific carbon nanotube aggregate, and thereby, the droplet is satisfactorily fixed on the surface of the carbon nanotube aggregate even under low temperature and high vacuum by virtue of excellent pressure-sensitive adhesive properties of the carbon nanotube aggregate. Accordingly, the cutting by focused ion beam (FIB) processing can be performed easily.

The carbon nanotube aggregate to be used in the droplet cutting method of the present invention can exhibit excellent conductive properties, and hence, charge up can be effectively reduced.

In the droplet cutting method of the present invention, the carbon nanotube aggregate may be provided on any appropriate base material. When the carbon nanotube aggregate is provided on any appropriate base material, any appropriate method may be adopted as a method of fixing the carbon nanotube aggregate onto the base material. Examples of such fixation method include: a method involving using a paste or the like to perform bonding; a method involving using a double-sided tape or the like to perform fixation based on pressure-sensitive adhesion; and a method involving using, as a shaft-shaped base material, a substrate used in the production of the carbon nanotube aggregate.

### «Carbon nanotube aggregate»

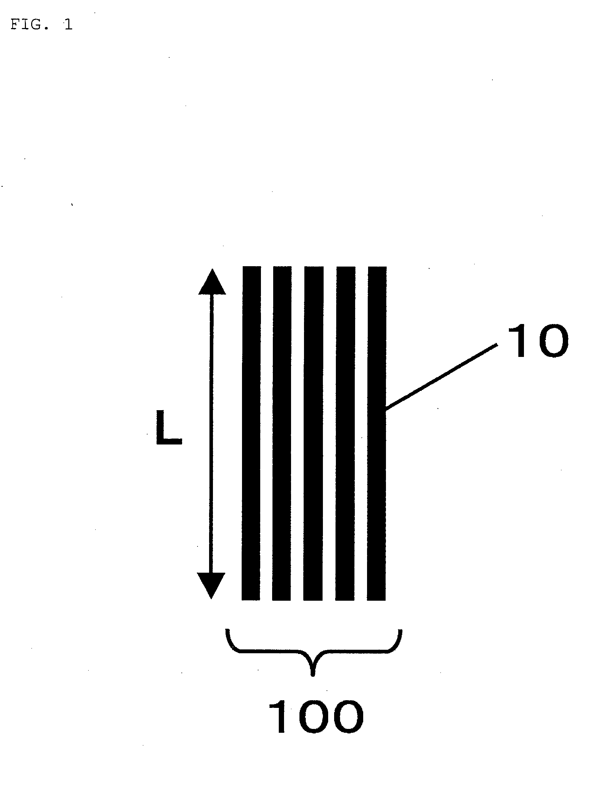

The carbon nanotube aggregate to be used in the droplet cutting method of the present invention includes a plurality of carbon nanotubes. FIG. 1 is a schematic sectional view of an example of a carbon nanotube aggregate to be used in a preferred embodiment of the present invention. In FIG. 1, a carbon nanotube aggregate 100 includes a plurality of carbon nanotubes 10. In FIG. 1, the plurality of carbon nanotubes 10 are each aligned in the direction of a length L.

The carbon nanotube aggregate to be used in the droplet cutting method of the present invention has a length of preferably from 1 µm to 10,000 µm, more preferably from 5 µm to 5,000 µm, still more preferably from 10 µm to 3,000 µm, particularly preferably from 30 µm to 2,000 µm, most preferably from 50 µm to 2,000 µm. When the length of the carbon nanotube aggregate to be used in the droplet cutting method of the present invention falls within the range, the carbon nanotube aggregate can exhibit an additionally excellent lotus effect (super water repellent effect) and additionally excellent pressure-sensitive adhesion property. Accordingly, when the droplet is placed on the surface of such carbon nanotube aggregate, it is possible to cut the droplet significantly easily to expose its cross-section.

The carbon nanotube aggregate to be used in the droplet cutting method of the present invention has a diameter of preferably from 0.1 nm to 2, 000 nm, more preferably from 0.3 nm to 2, 000 nm, still more preferably from 1 nm to 1,000 nm, particularly preferably from 2 nm to 500 nm. When the diameter of the carbon nanotube aggregate to be used in the droplet cutting method of the present invention falls within the range, the carbon nanotube aggregate can exhibit an additionally excellent lotus effect (super water repellent effect) and additionally excellent pressure-sensitive adhesion property. Accordingly, when the droplet is placed on the surface of such carbon nanotube aggregate, it is possible to cut the droplet significantly easily to expose its cross-section.

Regarding the shape of each of the carbon nanotubes included in the carbon nanotube aggregate to be used in the droplet cutting method of the present invention, the lateral section of the carbon nanotube only needs to have any appropriate shape. The lateral section is of, for example, a substantially circular shape, an oval shape, or an n-gonal shape (n represents an integer of 3 or more).

The specific surface area and density of each of the carbon nanotubes included in the carbon nanotube aggregate to be used in the droplet cutting method of the present invention may be set to any appropriate values.

Regarding the carbon nanotube aggregate to be used in the droplet cutting method of the present invention, two preferred embodiments as described below may be adopted.

### <First preferred embodiment>

A preferred embodiment (hereinafter sometimes referred to as "first preferred embodiment") of the carbon nanotube aggregate to be used in the droplet cutting method of the present invention includes a plurality of carbon nanotubes, in which the carbon nanotubes each have a plurality of walls, in which the distribution width of the wall number distribution of the carbon nanotubes is 10 walls or more, and in which the relative frequency of the mode of the wall number distribution is 25% or less.

The distribution width of the wall number distribution of the carbon nanotubes is 10 walls or more, preferably from 10 walls to 30 walls, more preferably from 10 walls to 25 walls, still more preferably from 10 walls to 20 walls.

The "distribution width" of the wall number distribution of the carbon nanotubes refers to a difference between the maximum wall number and minimum wall number of the wall numbers of the carbon nanotubes.

When the distribution width of the wall number distribution of the carbon nanotubes falls within the range, the carbon nanotubes can bring together excellent mechanical properties and a high specific surface area, andmoreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

The wall numbers and wall number distribution of the carbon nanotubes may be measured with any appropriate device. The wall numbers and wall number distribution of the carbon nanotubes are preferably measured with a scanning electron microscope (SEM) or a transmission electron microscope (TEM). For example, at least 10, preferably 20 or more carbon nanotubes may be taken out from a carbon nanotube aggregate to evaluate the wall numbers and the wall number distribution by the measurement with the SEM or the TEM.

The maximum wall number of the wall numbers of the carbon nanotubes is preferably from 5 to 30, more preferably from 10 to 30, still more preferably from 15 to 30, particularly preferably from 15 to 25.

The minimum wall number of the wall numbers of the carbon nanotubes is preferably from 1 to 10, more preferably from 1 to 5.

When the maximum wall number and minimum wall number of the wall numbers of the carbon nanotubes fall within the ranges, the carbon nanotubes can bring together additionally excellent mechanical properties and a high specific surface area, andmoreover, the carbon nanotubes can provide a carbon nanotube aggregate exhibiting additionally excellent pressure-sensitive adhesive property. Accordingly, when the droplet is placed on the surface of such carbon nanotube aggregate, it is possible to cut the droplet significantly easily to expose its cross-section.

The relative frequency of the mode of the wall number distribution is 25% or less, preferably from 1% to 25%, more preferably from 5% to 25%, still more preferably from 10% to 25%, particularly preferably from 15% to 25%. When the relative frequency of the mode of the wall number distribution falls within the range, the carbon nanotubes can bring together excellent mechanical properties and a high specific surface area, and moreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

The mode of the wall number distribution is present at preferably from 2 to 10 walls in number, more preferably from 3 to 10 walls in number. When the mode of the wall number distribution falls within the range, the carbon nanotubes can bring together excellent mechanical properties and a high specific surface area, and moreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

### <Second preferred embodiment>

Another preferred embodiment (hereinafter sometimes referred to as "second preferred embodiment") of the carbon nanotube aggregate to be used in the droplet cutting method of the present invention includes a plurality of carbon nanotubes, in which the carbon nanotubes each have a plurality of walls, in which the mode of the wall number distribution of the carbon nanotubes is present at 10 or less walls in number, and in which the relative frequency of the mode is 30% or more.

The distribution width of the wall number distribution of the carbon nanotubes is preferably 9 walls or less, more preferably from 1 wall to 9 walls, still more preferably from 2 walls to 8 walls, particularly preferably from 3 walls to 8 walls.

The "distribution width" of the wall number distribution of the carbon nanotubes refers to a difference between the maximum wall number and minimum wall number of the wall numbers of the carbon nanotubes.

When the distribution width of the wall number distribution of the carbon nanotubes falls within the range, the carbon nanotubes can bring together excellent mechanical properties and a high specific surf ace area, andmoreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

The wall numbers and wall number distribution of the carbon nanotubes may be measured with any appropriate device. The wall numbers and wall number distribution of the carbon nanotubes are preferably measured with a scanning electron microscope (SEM) or a transmission electron microscope (TEM). For example, at least 10, preferably 20 or more carbon nanotubes may be taken out from a carbon nanotube aggregate to evaluate the wall numbers and the wall number distribution by the measurement with the SEM or the

TEM.

The maximum wall number of the wall numbers of the carbon nanotubes is preferably from 1 to 20, more preferably from 2 to 15, still more preferably from 3 to 10.

The minimum wall number of the wall numbers of the carbon nanotubes is preferably from 1 to 10, more preferably from 1 to 5.

When the maximum wall number and minimum wall number of the wall numbers of the carbon nanotubes fall within the ranges, the carbon nanotubes can bring together additionally excellent mechanical properties and a high specific surface area, and moreover, the carbon nanotubes can provide a carbon nanotube aggregate exhibiting additionally excellent pressure-sensitive adhesive property. Accordingly, when the droplet is placed on the surface of such carbon nanotube aggregate, it is possible to cut the droplet significantly easily to expose its cross-section.

The relative frequency of the mode of the wall number distribution is 30% or more, preferably from 30% to 100%, more preferably from 30% to 90%, still more preferably from 30% to 80%, particularly preferably from 30% to 70%. When the relative frequency of the mode of the wall number distribution falls within the range, the carbon nanotubes can bring together excellent mechanical properties and a high specific surface area, and moreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

The mode of the wall number distribution is present at 10 or less walls in number, preferably from 1 to 10 walls in number, more preferably from 2 to 8 walls in number, still more preferably from 2 to 6 walls in number. In the present invention, when the mode of the wall number distribution falls within the range, the carbon nanotubes can bring together excellent mechanical properties and a high specific surface area, and moreover, the carbon nanotubes can provide a carbon nanotube aggregate exhibiting excellent pressure-sensitive adhesive property. Accordingly, when the droplet is placed on the surface of such carbon nanotube aggregate, it is possible to cut the droplet significantly easily to expose its cross-section.

### «Method of producing carbon nanotube aggregate»

Any appropriate method may be adopted as a method of producing the carbon nanotube aggregate to be used in the droplet cutting method of the present invention.

The method of producing the carbon nanotube aggregate to be used in the droplet cutting method of the present invention is, for example, a method of producing a carbon nanotube aggregate aligned substantially perpendicularly from a smooth substrate by chemical vapor deposition (CVD) involving forming a catalyst layer on the substrate and filling a carbon source in a state in which a catalyst is activated with heat, plasma, or the like to grow the carbon nanotubes. In this case, for example, the removal of the substrate provides a carbon nanotube aggregate aligned in a length direction.

Any appropriate substrate may be adopted as the substrate. The substrate is, for example, a material having smoothness and high-temperature heat resistance enough to resist the production of the carbon nanotubes. Examples of such material include quartz glass, silicon (such as a silicon wafer), and a metal plate made of, for example, aluminum.

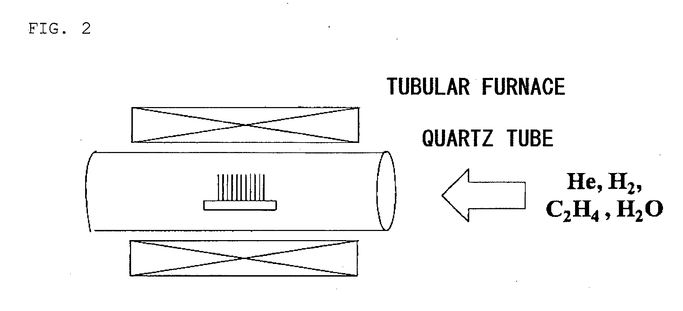

Any appropriate apparatus may be adopted as an apparatus for producing the carbon nanotube aggregate to be used in the droplet cutting method of the present invention. The apparatus is, for example, a thermal CVD apparatus of a hot wall type formed by surrounding a cylindrical reaction vessel with a resistance heating electric tubular furnace as illustrated in FIG. 2. In this case, for example, a heat-resistant quartz tube is preferably used as the reaction vessel.

Any appropriate catalyst may be used as the catalyst (material for the catalyst layer) that may be used in the production of the carbon nanotube aggregate to be used in the droplet cutting method of the present invention. Examples of the catalyst include metal catalysts such as iron, cobalt, nickel, gold, platinum, silver, and copper.

Upon production of the carbon nanotube aggregate to be used in the droplet cutting method of the present invention, an alumina/hydrophilic film may be formed between the substrate and the catalyst layer as required.

Any appropriate method may be adopted as a method of producing the alumina/hydrophilic film. For example, the film may be obtained by producing a SiO₂ film on the substrate, depositing Al from the vapor, and increasing the temperature of Al to 450°C after the deposition to oxidize Al. According to such production method, Al₂O₃ interacts with the hydrophilic SiO₂ film, and hence an Al₂O₃ surface different from that obtained by directly depositing Al₂O₃ from the vapor in particle diameter is formed. When Al is deposited from the vapor, and then its temperature is increased to 450 °C so that Al may be oxidized without the production of any hydrophilic film on the substrate, it may be difficult to form the Al₂O₃ surface having a different particle diameter. In addition, when the hydrophilic film is produced on the substrate and Al₂O₃ is directly deposited from the vapor, it may also be difficult to form the Al₂O₃ surface having a different particle diameter.

The catalyst layer that may be used in the production of the carbon nanotube aggregate to be used in the droplet cutting method of the present invention has a thickness of preferably from 0.01 nm to 20 nm, more preferably from 0.1 nm to 10 nm in order that fine particles may be formed. When the thickness of the catalyst layer that may be used in the production of the carbon nanotube aggregate included in the particle adsorption probe of the present invention falls within the range, the carbon nanotube aggregate can bring together excellent mechanical properties and a high specific surface area, and moreover, the carbon nanotube aggregate can exhibit excellent pressure-sensitive adhesive property. Accordingly, when the droplet is placed on the surface of such carbon nanotube aggregate, it is possible to cut the droplet significantly easily to expose its cross-section.

Any appropriate method may be adopted as a method of forming the catalyst layer. Examples of the method include a method involving depositing a metal catalyst from the vapor, for example, with an electron beam (EB) or by sputtering and a method involving applying a suspension of metal catalyst fine particles onto the substrate.

After its formation, the catalyst layer may be processed by a photolithographic process so as to have a pattern having any appropriate diameter. When such photolithographic process is performed, a carbon nanotube aggregate having a desired diameter can be produced in the end.

Any appropriate carbon source may be used as the carbon source that may be used in the production of the carbon nanotube aggregate to be used in the droplet cutting method of the present invention. Examples thereof include: hydrocarbons such as methane, ethylene, acetylene, and benzene; and alcohols such as methanol and ethanol.

Any appropriate temperature may be adopted as a production temperature in the production of the carbon nanotube aggregate to be used in the droplet cutting method of the present invention. For example, the temperature is preferably from 400°C to 1,000°C, more preferably from 500°C to 900°C, still more preferably from 600°C to 800°C in order that catalyst particles allowing sufficient expression of the effects of the present invention may be formed.

### «Droplet cross-section analysis method»

A droplet cross-section analysis method of the present invention includes analyzing a cross-section exposed through cutting by the droplet cutting method of the present invention.

The droplet cross-section analysis method of the present invention preferably includes analyzing with a scanning electron microscope (SEM) a cross-section exposed through cutting by the droplet cutting method of the present invention. As just described, processing of a cross-section and analysis with a scanning electron microscope (SEM) are performed in combination. The processing of a cross-section and the SEM analysis are performed intermittently and repeatedly, and the obtained images are sterically reconstructed. Thus, structural analysis of a cross-section of a droplet in three dimensions, which has been hitherto extremely difficult, is realized.

The droplet cross-section analysis method of the present invention is preferably an analysis method using a FIB-SEM apparatus combining focused ion beam (FIB) processing and scanning electron microscope (SEM) analysis. When the droplet cross-section analysis method of the present invention is an analysis method using a FIB-SEM apparatus, the droplet cutting method of the present invention is used at the time of the focused ion beam (FIB) processing. As the FIB-SEM apparatus, any appropriate FIB-SEM apparatus may be adopted. As the analysis conditions for the FIB-SEM apparatus, any appropriate analysis conditions may be adopted.

### Examples

The present invention is hereinafter described by way of Examples. However, the present invention is not limited thereto. It should be noted that various evaluations and measurements were performed by the following methods.

### <Measurement of length and diameter of carbon nanotube aggregate>

The length and diameter of a carbon nanotube aggregate were measured with a scanning electron microscope (SEM).

### <Evaluation of wall numbers and wall number distribution of carbon nanotubes in carbon nanotube aggregate>

The wall numbers and wall number distribution of carbon nanotubes in the carbon nanotube aggregate were measured with a scanning electron microscope (SEM) and/or a transmission electron microscope (TEM). At least 10 or more, preferably 20 or more carbon nanotubes in the obtained carbon nanotube aggregate were observed with the SEM and/or the TEM to check the wall number of each carbon nanotube, and the wall number distribution was created.

### <Measurement of contact angle>

A contact angle was determined by dropping water of 1 µl or more and 4 µl or less on the surface of a solid and in accordance with a measurement method generally well known as a so-called "θ/2 method", in which the contact angle was determined based on an angle between a straight line connecting right and left endpoints of the droplet to the apex thereof and the surface of the solid. According to the "θ/2 method", the contact angle can be measured by direct reading using a scale such as a protractor. Alternatively, the contact angle can be measured by analysis using a computer in a short-time process, because its calculation is easy.

### <Evaluation of state of spherical shape of droplet upon FIB processing>

Upon FIB processing, a droplet was evaluated for its state of spherical shape according to the following criteria.
○: The contact angle is 130 degrees or more.
Δ: The contact angle is 110 degrees or more and less than 130 degrees.
×: The contact angle is less than 110 degrees.

### <FIB processing method>

A carbon nanotube aggregate was attached to a sample stage of a SEM and immersed in liquid nitrogen to be cooled. After that, a water droplet was fixed on the carbon nanotube aggregate through rapid freezing, and then, moved to a FIB-SEM complex apparatus while being prevented from exposure to the atmosphere. While the cooling state was maintained, FIB processing was performed to produce a cross-section of the water droplet.

### <SEM analysis method for cross-section obtained by FIB processing>

The cross-section of the water droplet, which was obtained by FIB processing using a FIB-SEM complex apparatus while the cooling state was maintained, was analyzed with a SEM.

### <Evaluation of fixed state of droplet>

Upon production of a cross-section of a water droplet by FIB processing, the case where the cross-section was formed in a state in which the water droplet was fixed on a carbon nanotube aggregate was evaluated as having a good fixed state (○), and any other case was evaluated as having a poor fixed state (×).

### <Evaluation of state of cross-section obtained by FIB processing>

Whether or not an inner portion of a water droplet was able to be observed without any influence of the sample stage was confirmed. The case where the water droplet maintained its circular shape by virtue of the super water repellent effect of a carbon nanotube aggregate, deformation and the like due to stress were not found upon rapid freezing, and the inner configuration of the original droplet was able to be observed was evaluated as having a good state of cross-section (○), and any other case was evaluated as having a poor state of cross-section (×).

### [Example 1]

An Al thin film (thickness: 5 nm) was formed on a silicon wafer (manufactured by Silicon Technology Co., Ltd.) as a substrate with a sputtering apparatus (RFS-200 manufactured by ULVAC, Inc.). An Fe thin film (thickness: 0.35 nm) was further deposited from the vapor onto the Al thin film with the sputtering apparatus (RFS-200 manufactured by ULVAC, Inc.).

After that, the substrate was mounted in a quartz tube having a diameter of 30 mm, and a helium/hydrogen (90/50 sccm) mixed gas whose moisture content had been held at 600 ppm was flowed into the quartz tube for 30 minutes to replace the inside of the tube. After that, a temperature in the tube was increased with an electric tubular furnace to 765°C and stabilized at 765°C. While the temperature was held at 765°C, the inside of the tube was filled with a helium/hydrogen/ethylene (85/50/5 sccm, moisture content: 600 ppm) mixed gas, and the resultant was left to stand for 4 minutes to grow carbon nanotubes on the substrate. Thus, a carbon nanotube aggregate (1) in which the carbon nanotubes were aligned in their length directions was obtained.

The carbon nanotube aggregate (1) had a length of 50 µm.

In the wall number distribution of the carbon nanotubes included in the carbon nanotube aggregate (1), a mode was present at 1 wall, and its relative frequency was 61%.

The obtained carbon nanotube aggregate (1) was pressure-bonded onto a sample stage of an analyzer to be fixed thereon, and was used as a sample table for placing a droplet for FIB processing. By using this sample table, FIB processing, and SEM analysis of a cross-section obtained by the FIB processing were performed.

The evaluation results are shown in Table 1.

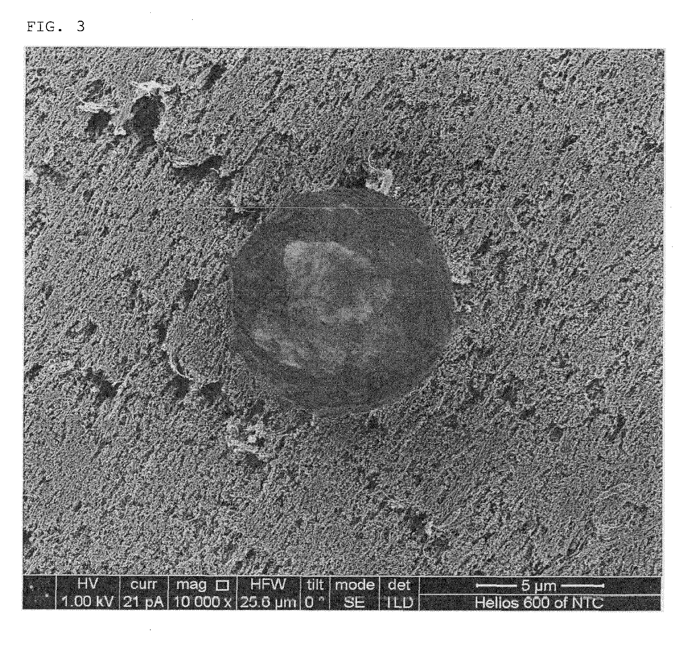

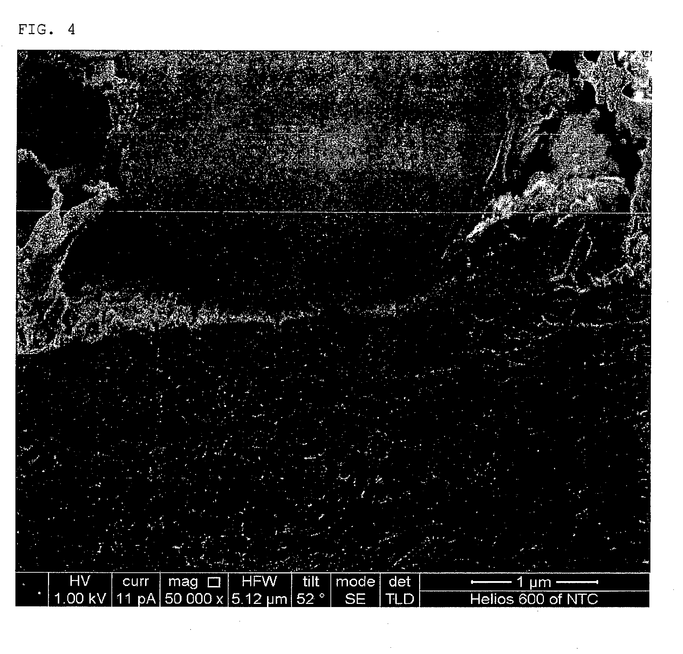

In addition, FIG. 3 shows a photographic view provided by a scanning electron microscope (SEM) showing a state in which the droplet is placed on the surface of the carbon nanotube aggregate, the photographic view being taken from above the surface. FIG. 4 shows a photographic view provided by a scanning electron microscope (SEM) showing a state of the cross-section exposed through cutting by the FIB processing.

### [Example 2]

An alumina thin film (thickness: 20 nm) was formed on a silicon wafer (manufactured by Silicon Technology Co. , Ltd.) as a substrate with a sputtering apparatus (RFS-200 manufactured by ULVAC, Inc.). An Fe thin film (thickness: 1 nm) was further deposited from the vapor onto the alumina thin film with the sputtering apparatus (RFS-200 manufactured by ULVAC, Inc.).

After that, the substrate was mounted in a quartz tube having a diameter of 30 mm, and a helium/hydrogen (90/50 sccm) mixed gas whose moisture content had been held at 600 ppm was flowed into the quartz tube for 30 minutes to replace the inside of the tube. After that, a temperature in the tube was increased with an electric tubular furnace to 765°C and stabilized at 765°C. While the temperature was held at 765°C, the inside of the tube was filled with a helium/hydrogen/ethylene (85/50/5 sccm, moisture content: 600 ppm) mixed gas, and the resultant was left to stand for 10 minutes to grow carbon nanotubes on the substrate. Thus, a carbon nanotube aggregate (2) in which the carbon nanotubes were aligned in their length directions was obtained.

The carbon nanotube aggregate (2) had a length of 200 µm.

In the wall number distribution of the carbon nanotubes included in the carbon nanotube aggregate (2), a mode was present at 2 walls, and its relative frequency was 75%.

The obtained carbon nanotube aggregate (2) was used as it was as a sample table for placing a droplet for FIB processing. By using this sample table, FIB processing, and SEM analysis of a cross-section obtained by the FIB processing were performed.

The evaluation results are shown in Table 1.

### [Example 3]

An Al thin film (thickness: 5 nm) was formed on a silicon wafer (manufactured by Silicon Technology Co., Ltd.) as a substrate with a sputtering apparatus (RFS-200 manufactured by ULVAC, Inc.). An Fe thin film (thickness: 2 nm) was further deposited from the vapor onto the Al thin film with the sputtering apparatus (RFS-200 manufactured by ULVAC, Inc.).

After that, the substrate was mounted in a quartz tube having a diameter of 30 mm, and a helium/hydrogen (90/50 sccm) mixed gas whose moisture content had been held at 600 ppm was flowed into the quartz tube for 30 minutes to replace the inside of the tube. After that, a temperature in the tube was increased with an electric tubular furnace to 765°C and stabilized at 765°C. While the temperature was held at 765°C, the inside of the tube was filled with a helium/hydrogen/ethylene (85/50/5 sccm, moisture content: 600 ppm) mixed gas, and the resultant was left to stand for 20 minutes to grow carbon nanotubes on the substrate. Thus, a carbon nanotube aggregate (3) in which the carbon nanotubes were aligned in their length directions was obtained.

The carbon nanotube aggregate (3) had a length of 500 µm.

In the wall number distribution of the carbon nanotubes included in the carbon nanotube aggregate (3), a mode was present at 3 walls, and its relative frequency was 72%.

The obtained carbon nanotube aggregate (3) was used as it was as a sample table for placing a droplet for FIB processing. By using this sample table, FIB processing, and SEM analysis of a cross-section obtained by the FIB processing were performed.

The evaluation results are shown in Table 1.

### [Example 4]

An Al thin film (thickness: 10 nm) was formed on a silicon substrate (wafer having a thermal oxide film manufactured by KST World Corp., thickness: 1,000 µm) with a vacuum deposition apparatus (JEE-4X Vacuum Evaporator manufactured by JEOL Ltd.), and then, oxidation treatment was performed at 450°C for 1 hour. Thus, an Al₂O₃ film was formed on the silicon substrate. Further, a Fe thin film (thickness: 2 nm) was deposited on the Al₂O₃ film with a sputtering apparatus (RFS-200 manufactured by ULVAC, Inc.) to form a catalyst layer.

After that, the substrate was mounted in a quartz tube having a diameter of 30 mm, and a helium/hydrogen (120/80 sccm) mixed gas whose moisture content had been held at 350 ppm was flowed into the quartz tube for 30 minutes to replace the inside of the tube. After that, a temperature in the tube was increased with an electric tubular furnace to 765°C and stabilized at 765°C. While the temperature was held at 765°C, the inside of the tube was filled with a helium/hydrogen/ethylene (105/80/15 sccm, moisture content: 350 ppm) mixed gas, and the resultant was left to stand for 60 minutes to grow carbon nanotubes on the substrate. Thus, a carbon nanotube aggregate (4) in which the carbon nanotubes were aligned in their length directions was obtained.

The carbon nanotube aggregate (4) had a length of 1,000 µm.

In the wall number distribution of the carbon nanotubes included in the carbon nanotube aggregate (4), the distribution width of the wall number distribution was 17 walls (4 to 20 walls), modes were present at 2 walls and 8 walls, and their relative frequencies were 20% and 20%, respectively.

The obtained carbon nanotube aggregate (4) was used as it was as a sample table for placing a droplet for FIB processing. By using this sample table, FIB processing, and SEM analysis of a cross-section obtained by the FIB processing were performed.

The evaluation results are shown in Table 1.

### [Comparative Example 1]

A conductive carbon double-sided tape (731 manufactured by Nisshin EM Corporation) was used as it was as a sample table for placing a droplet for FIB processing. By using this sample table, FIB processing and SEM analysis of a cross-section obtained by the FIB processing were performed.

The evaluation results are shown in Table 1.

**[Table 1]**

| | | Length of CNT aggregate (µm) | Contact angle (degree) | State of spherical shape of droplet | Fixed state of droplet | State of cross-section obtained by FIB processing |
|---|---|---|---|---|---|---|
| Example 1 | SW-61 | 50 | 135.5 | ○ | ○ | ○ |
| Example 2 | DW-75 | 200 | 138.8 | ○ | ○ | ○ |
| Example 3 | TW-72 | 500 | 140.0 | ○ | ○ | ○ |
| Example 4 | Broad | 1,000 | 138.1 | ○ | ○ | ○ |
| Comparative Example 1 | Conductive carbon double-sided tape | - | 107.1 | Δ | × | × |

Table 1 reveals that, according to the droplet cutting method of the present invention and the droplet cross-section analysis method of the present invention, a droplet can maintain its state of having a good spherical shape on the surface of a carbon nanotube aggregate used as a sample table for placing a droplet for FIB processing, the droplet can be satisfactorily fixed on the surface, the state of a cross-section obtained by FIB processing is excellent. Thus, it is found that, according to the cutting method and analysis method of the present invention, a droplet can be easily cut to expose its cross-section, and the exposed cross-section can be easily analyzed.

### Industrial Applicability

The droplet cutting method of the present invention and the droplet cross-section analysis method of the present invention can be utilized for, for example, observation of a dispersion state of particles in a particle dispersion liquid such as an emulsion or a slurry.

### Reference Signs List

- **100**: carbon nanotube aggregate
- **10**: carbon nanotube

## Claims

1. A droplet cutting method for cutting a droplet to expose a cross-section, the method comprising:
placing a droplet on a surface of a carbon nanotube aggregate including a plurality of carbon nanotubes;
cooling the droplet to a cooling temperature equal to or less than a temperature at which the droplet is solidified; and
cutting the droplet.

2. A droplet cutting method according to claim 1, wherein the droplet has a contact angle of 110 degrees or more with respect to the surface.

3. A droplet cutting method according to claim 1, wherein the cutting is performed by focused ion beam processing.

4. A droplet cutting method according to claim 1, wherein the cooling temperature is -100°C or less.

5. A droplet cutting method according to claim 1,
wherein the carbon nanotubes each have a plurality of walls,
wherein a distribution width of a wall number distribution of the carbon nanotubes is 10 walls or more, and
wherein a relative frequency of a mode of the wall number distribution is 25% or less.

6. A droplet cutting method according to claim 1,
wherein the carbon nanotubes each have a plurality of walls,
wherein a mode of a wall number distribution of the carbon nanotubes is present at 10 or less walls in number, and
wherein a relative frequency of the mode is 30% or more.

7. A droplet cross-section analysis method, comprising analyzing a cross-section exposed through cutting by the droplet cutting method according to claim 1.
